# EUROPEAN PATENT APPLICATION

(11) **EP 2 175 498 A2**
(43) Date of publication of application: **14.04.2010**
(21) Application number: 09010979.4
(22) Date of filing: 27.08.2009
(51) Int. Cl.: H01L 33/48

(54) **Light emitting device**

(30) Priority: 12.09.2008 JP 2008234874
(71) Applicant: Kabushiki Kaisha Toshiba, Minato-ku Tokyo (JP)
(72) Inventor: Ono, Reiji, Minato-ku Tokyo (JP)
(74) Representative: HOFFMANN EITLE

(57) **Abstract**

A light emitting device includes: a first substrate with an end surface formed by separation on its outer edge; a second substrate including on its upper surface a first electrode and a second electrode, and at its side corner a first extraction electrode connected to the first electrode and a second extraction electrode connected to the second electrode, one end portion of the second electrode being opposed to one end portion of the first electrode, the second substrate being laminated on the first substrate so that an outer edge of the second substrate is located inside the outer edge of the first substrate; a light emitting element bonded to the first electrode; and a third substrate including a first through hole which allows emission of emitted light from the light emitting element, the third substrate being laminated on the second substrate so that an outer edge of the third substrate is located inside the outer edge of the first substrate.

## Description

### CROSS-REFERENCE RELATED APPLICATIONS

This application is based upon and claims the benefit of priority from the prior Japanese Patent Application No.2008-234874, filed on September 12, 2008; the entire contents of which are incorporated herein by reference.

### BACKGROUND OF THE INVENTION

### Field of the Invention

This invention relates to a light emitting device.

### Background Art

Use of a white LED as a display backlight source facilitates reducing its power consumption, size, and profile as compared with a cold cathode tube.

Furthermore, in view of increasing the size and definition of a display device, a high power LED is required. If a package for mounting such an LED is made of a ceramic or glass epoxy insulating substrate, then smaller size, lower profile, and higher power are easily achieved.

However, a sealing resin dispersed with phosphors is filled in the recess of a white LED package, which results in increasing its height-to-width ratio. Hence, separation into individual light emitting devices may cause burrs and chips, which make the separation difficult. Furthermore, the side surface of the separated package may fail to be planar, which causes the problem of making it difficult to align the optical axis of the light emitting device with a desired angular direction after soldering.

JP-A-2005-159311(Kokai) discloses an example technique related to a ceramic support body for a semiconductor element. In producing a semiconductor device according to this example, the ceramic substrate is separated by applying a bending moment thereto with a point of application set on the major surface of the ceramic substrate while applying a tension moment in a direction parallel to the major surface.

However, even this example is insufficient to reliably separate a package in which insulators having a large thickness-to-width ratio are laminated. Thus, for instance, it is difficult to attach a side-view type light emitting device to a mounting substrate with a desired angle, which causes the problem of nonuniformity in the brightness of the display screen.

### SUMMARY OF THE INVENTION

According to an aspect of the invention, there is provided a light emitting device including: a first substrate with an end surface formed by separation on its outer edge; a second substrate including on its upper surface a first electrode and a second electrode, and at its side corner a first extraction electrode connected to the first electrode and a second extraction electrode connected to the second electrode, one end portion of the second electrode being opposed to one end portion of the first electrode, the second substrate being laminated on the first substrate so that an outer edge of the second substrate is located inside the outer edge of the first substrate; a light emitting element bonded to the first electrode; and a third substrate including a first through hole which allows emission of emitted light from the light emitting element, the third substrate being laminated on the second substrate so that an outer edge of the third substrate is located inside the outer edge of the first substrate.

According to other aspect of the invention, there is provided a light emitting device including: a light emitting element; a first substrate with an end surface formed by separation on its outer edge; a second substrate including on its upper surface a first electrode and a second electrode, at its side corner a first extraction electrode connected to the first electrode and a second extraction electrode connected to the second electrode, and on its side surface a side electrode connected to a bonding region of the first electrode on which the light emitting element is bonded, one end portion of the second electrode being opposed to one end portion of the first electrode, the second substrate being laminated on the first substrate so that an outer edge of the second substrate is located inside the outer edge of the first substrate; a third substrate including a first through hole which allows emission of emitted light from the light emitting element, the third substrate being laminated on the second substrate so that an outer edge of the third substrate is located inside the outer edge of the first substrate; and a fourth substrate with an end surface formed by separation on its outer edge, the fourth substrate including a second through hole having a size equal to or larger than the size of the first through hole, and the fourth substrate being laminated on the third substrate so that the outer edge of the fourth substrate is generally matched with the outer edge of the first substrate.

According to other aspect of the invention, there is provided a light emitting device including: a first substrate with an end surface formed by separation on its outer edge, the first substrate including on its upper surface a first electrode and a second electrode, and at its side corner a first extraction electrode connected to the first electrode and a second extraction electrode connected to the second electrode, one end portion of the second electrode being opposed to one end portion of the first electrode; a light emitting element bonded to the first electrode; and a third substrate including a first through hole which allows emission of emitted light from the light emitting element, the third substrate being laminated above the first substrate so that an outer edge of the third substrate is located inside the outer edge of the first substrate.

### BRIEF DESCRIPTION OF THE DRAWINGS

FIGS. 1A to 1D are schematic views of a light emitting device according to a first embodiment;
FIG. 2A to 2D are schematic views of a light emitting device according to a second embodiment;
FIG. 3A to 3F are schematic plan views of a substrate before lamination;
FIG. 4A to 4E are schematic views of a light emitting device of a comparative example;
FIG. 5A to 5C are schematic views of a light emitting device of a third embodiment; and
FIG. 6A to 6D are schematic views of a light emitting device of a forth embodiment.

### DETAILED DESCRIPTION OF THE INVENTION

Embodiments of the invention will now be described with reference to the drawings.

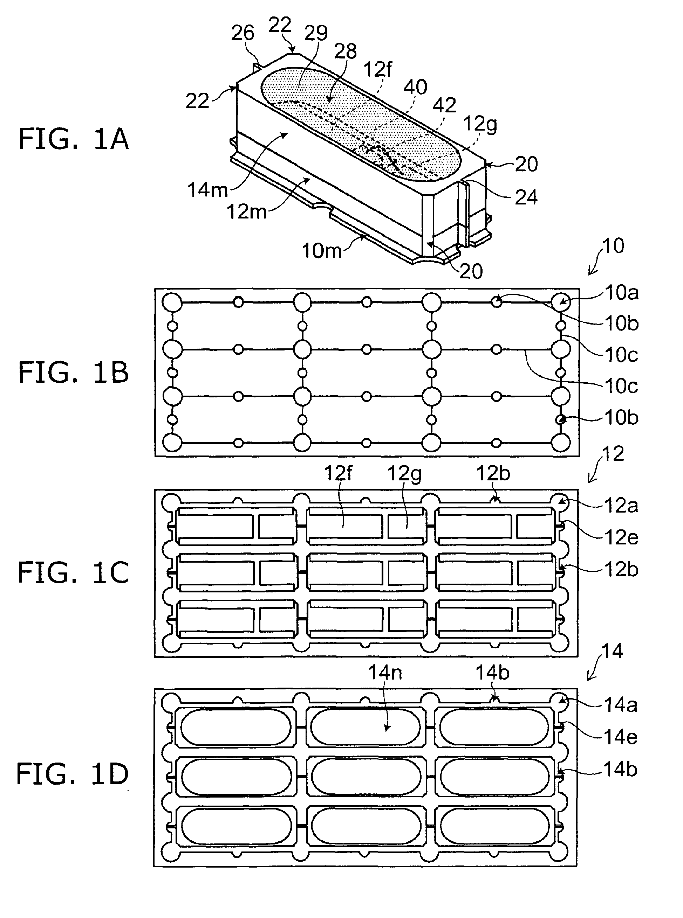

FIG. 1A is a schematic perspective view of a light emitting device according to a first embodiment of the invention, FIG. 1B is a schematic plan view of a first substrate, FIG. 1C is a schematic plan view of a second substrate, and FIG. 1D is a schematic plan view of a third substrate.

The substrates can be made of Al₂O₃, AIN or other ceramic material, or glass epoxy material. In the embodiment of FIG. 1, the substrates are made of an Al₂O₃ ceramic. The first substrate 10, the second substrate 12, and the third substrate 14 shown in FIG. 1 are substrates before lamination. These substrates are stacked and fired into a laminated body, which is used for the light emitting device shown in FIG. 1A.

The light emitting device includes a recess 28, and a light emitting element 40 is bonded to a bottom surface of the recess 28. Extraction electrodes 20, 22 are provided at the side corners of the light emitting device and allow electric power such as a voltage and a current to be supplied to the light emitting element 40.

As shown in FIG. 1B, the first substrate 10 illustratively has a long side of 4 mm, a short side of 1 mm, and a thickness of 0.1 mm. The second substrate 12 laminated on the first substrate 10 and the third substrate 14 laminated on the second substrate 12 each have a long side of 3.8 mm and a short side of 0.8 mm, which are smaller than those of the first substrate 10. That is, in the laminated body, an outer edge 10m of the first substrate 10 has an end surface formed by separation. The outer edge 10m of the first substrate 10 is located outside an outer edge 12m of the second substrate 12 and an outer edge 14m of the third substrate 14. The outer edge 12m of the second substrate 12 and the outer edge 14m of the third substrate 14 are generally aligned with each other as viewed from above.

The first substrate 10 before lamination has V-grooves 10c generally orthogonal to each other, which can facilitate the process of separation into individual light emitting devices. Although the number of separation is 3x3 in FIG. 1B, the number of separation can be increased to e.g. 20x20 to enhance the productivity of the light emitting device. Furthermore, a via hole 10a is provided in a region which is to serve as a notch after separation, and a gas vent (as a vent for the sintering process) 10b is provided generally at the center of each side.

As shown in FIG. 1C, first electrodes 12f and second electrodes 12g are formed on a surface of the second substrate 12 by thick film printing so that, for instance, the light emitting element 40 can be bonded onto the first electrode 12f using silver paste or other adhesive. An electrode on an upper surface of the light emitting element 40 can be connected to the second electrode 12g by a bonding wire 42.

Furthermore, the second substrate 12 includes via holes 12a and gas vents 12b so that their positions are generally aligned with those of the via holes 10a and gas vents 10b of the first substrate 10. When the second substrate 12 is stacked on the first substrate 10, an opening is formed in the vicinity immediately above the V-groove 10c. Hence, individual package units constituting the second substrate 12 are coupled to each other by at least two coupling portions 12e. Separation is facilitated if this coupling portion 12e can be provided so as to traverse the gas vent 10b, for instance.

A first extraction electrode 22 connected to the first electrode 12f and a second extraction electrode 20 connected to the second electrode 12g are formed by side surface metallization on the inner wall of the via hole 12a of the second substrate 12, facilitating attachment to a mounting substrate.

As shown in FIG. 1D, the third substrate 14 includes first through holes 14n each constituting the recess 28 of the laminated body. The recess 28 is filled with a sealing resin 29, which allows emitted light from the light emitting element 40 to be emitted upward. The first through hole 14n illustratively has a long diameter of 3 mm and a short diameter of 0.5 mm. Furthermore, via holes 14a, gas vents 14b, and coupling portions 14e are formed so that their positions are generally aligned with those of the second substrate 12.

The inner wall of each substrate is metallized, and separation is performed after lamination. Then, as shown in FIG. 1A, the extraction electrodes 20, 22 can be extended throughout the surface of the notch. This ensures soldering to a mounting substrate. Preferably, gold plating, for instance, is performed on the first and second extraction electrode 20, 22 formed illustratively by thick film printing. This can prevent oxidation of the electrode surface, and ensure soldering to a mounting substrate.

The fired laminated body can be easily separated at the V-groove 10c by using a roller, for instance, to apply a pressure to the V-groove 10c. In this case, if the first substrate 10 is thinned to 0.1 mm, the end surface 10m formed by separation can avoid burrs, chips and the like, allowing reliable separation and facilitating accurate attachment to a mounting substrate.

The light emitting device of FIG. 1 can be used as a top-view type device. The sealing resin 29 can illustratively be silicone resin, in which phosphor particles can be dispersed. This can provide mixed light of emitted light from the light emitting element 40 and wavelength-converted light from the phosphor particles. Thus, a white or incandescent color can be obtained as a mixed color of blue light from the light emitting element 40 made of nitride semiconductors and yellow light from yellow phosphors.

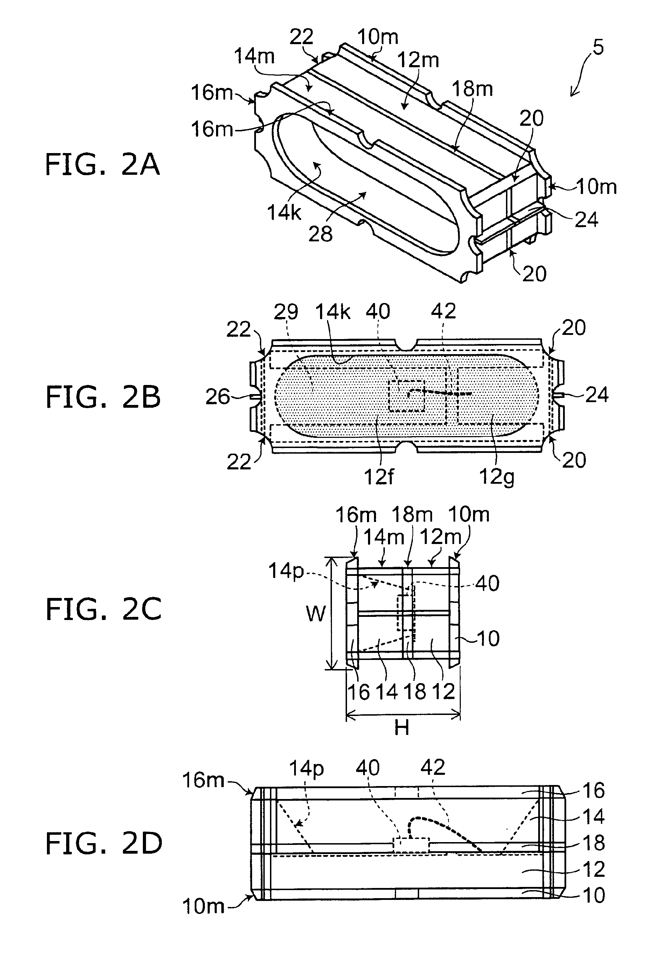

FIG. 2A is a schematic perspective view of the laminated body of a light emitting device according to a second embodiment, FIG. 2B is a schematic plan view of the light emitting device, FIG. 2C is a schematic side view of the light emitting device, and FIG. 2D is a schematic front view of the light emitting device.

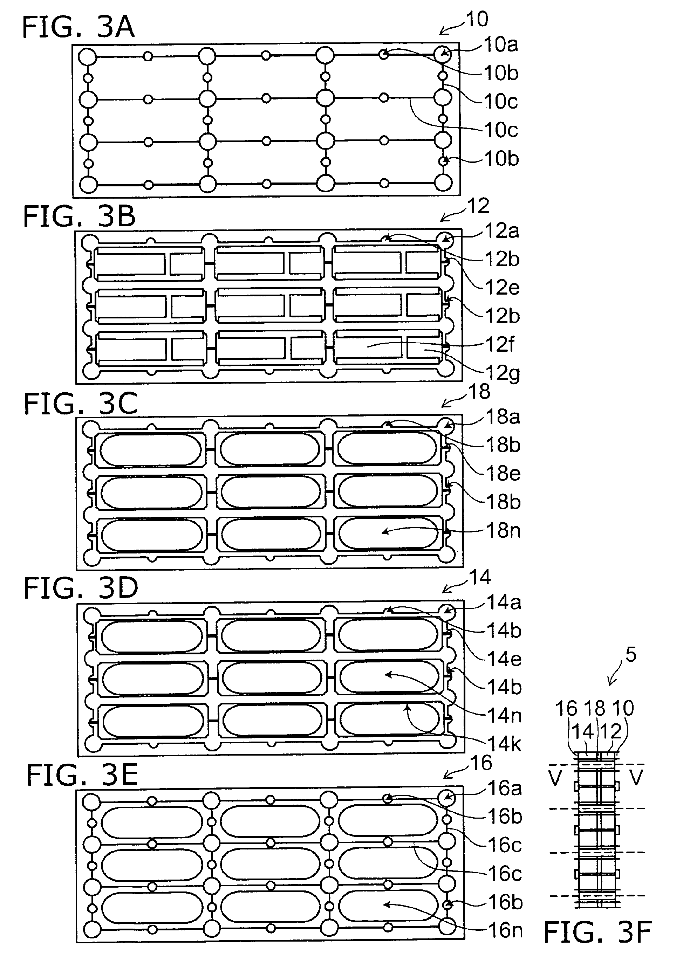

FIG. 3A is a schematic plan view of a first substrate constituting the laminated body 5, FIG. 3B is a schematic plan view of a second substrate, FIG. 3C is a schematic plan view of a fifth substrate, FIG. 3D is a schematic plan view of a third substrate, FIG. 3E is a schematic plan view of a fourth substrate, and FIG. 3F is a side view of the laminated body before separation.

In this embodiment, an outer edge 10m of the first substrate 10 constituting the lowermost layer and an outer edge 16m of the fourth substrate 16 constituting the uppermost layer have an end surface formed by separation. Furthermore, a plurality of through holes in the plurality of substrates constitute a recess 28.

The first substrate 10 and the fourth substrate 16 illustratively have a long side of 4 mm, a short side of 1 mm, and a thickness of 0.1 mm. The second substrate 12 laminated on the first substrate 10, the fifth substrate 18 laminated on the second substrate 12, and the third substrate 14 laminated on the fifth substrate 18 each have a long side of 3.8 mm and a short side of 0.8 mm, which are smaller than those of the first substrate 10 and the fourth substrate 16. That is, as shown in FIG. 2, in the laminated body 5, the outer edges 10m, 16m of the first substrate 10 and the fourth substrate 16 have an end surface formed by separation. The outer edges 10m, 16m are located outside the outer edges 12m, 18m, and 14m of the second, fifth, and third substrate 12, 18, 14.

After the sintering process, each substrate is formed so that the positions of via holes 10a, 12a, 18a, 14a, 16a, gas vents 10b, 12b, 18b, 14b, 16b, coupling portions 12e, 18e, and 14e are generally aligned with each other, respectively. When the sintered laminated body 5 is separated, the via hole turns to a notch at the four side corners. Furthermore, the coupling portion provided near the center line of the gas vent is separated into protrusions 24, 26.

The V-groove 10c of the first substrate 10 and the V-groove 16c of the fourth substrate 16 are laminated so as to be generally matched (so that their positions are generally aligned) with each other as viewed from above, providing a hollow structure between the V-groove 10c and the V-groove 16c.

The second substrate 12 has a first electrode 12f and a second electrode 12g on its surface. A first extraction electrode 22 connected to the first electrode 12f and a second extraction electrode 20 connected to the second electrode 12g are formed by side surface metallization on the inner wall of the via hole 12a, facilitating electrical connection and attachment to a mounting substrate.

The third substrate 14 includes a first through hole 14n. The fourth substrate 16 includes a second through hole 16n having a size equal to or larger than that of the first through hole 14n. The fifth substrate 18 includes a third through hole 18n having generally the same shape as the first through hole 14n. When these through holes are laminated and sintered, the recess 28 of the laminated body 5 is formed.

If a reflecting layer 14k illustratively made of silver or other metal is formed on an inner wall of the through hole 14n of the third substrate 14, emitted light from the light emitting element 40 can be emitted upward, which facilitates increasing the light extraction efficiency. In this case, if the fifth substrate 18 has a thickness of e.g. 0.1 mm and is sandwiched between the second substrate 12 and the third substrate 14, it functions as an isolation layer for preventing short circuit between the first electrode 12f and the second electrode 12g. Here, isolation can also be achieved by providing a non-formation region of the reflecting layer on the lower portion of the inner wall of the through hole 14n of the third substrate 14. In this case, the fifth substrate 18 can be omitted. If a bevel 14p is provided on the inner wall of the through hole 14n so that emitted light is reflected upward, the light extraction efficiency can be further increased.

As shown in FIG. 2, the ratio of height H to width W of this laminated body 5 may be 1 or more.

However, the fourth substrate 16 constituting the uppermost layer and the first substrate 10 constituting the lowermost layer are thinned to e.g. 0.1 mm. Thus, even such a thick laminated body 5 can be easily separated by using a roller or the like to apply a pressure in the direction of line V-V along which the V-groove 10c, 16c is formed, and the end surface formed by separation can avoid burrs and chips, because the laminated body 5 is hollow as shown in FIG. 3F.

Such a light emitting device can be used as a side-view type or top-view type device. In the side-view type, the lateral side of the light emitting device is bonded to a mounting substrate using solder or the like. More specifically, the extraction electrodes 20, 22 provided on the notch are each soldered to a conductive portion of the mounting substrate. Then, an optical axis along which emitted light from the light emitting element 40 has a maximum intensity can be easily made generally parallel to the plane to which the outer edge 10m of the first substrate 10 and the outer edge 16m of the fourth substrate 16 are attached in contact therewith.

In the case where the side-view type light emitting device is used as a backlight source of a display device, a thickness of a light guide plate of the display device is illustratively 1 mm or less. The width W of the light emitting device of this embodiment can be easily set to 1 mm or less. Thus, emitted light of the light emitting element 40 can be laterally incident on the light guide plate with high efficiency.

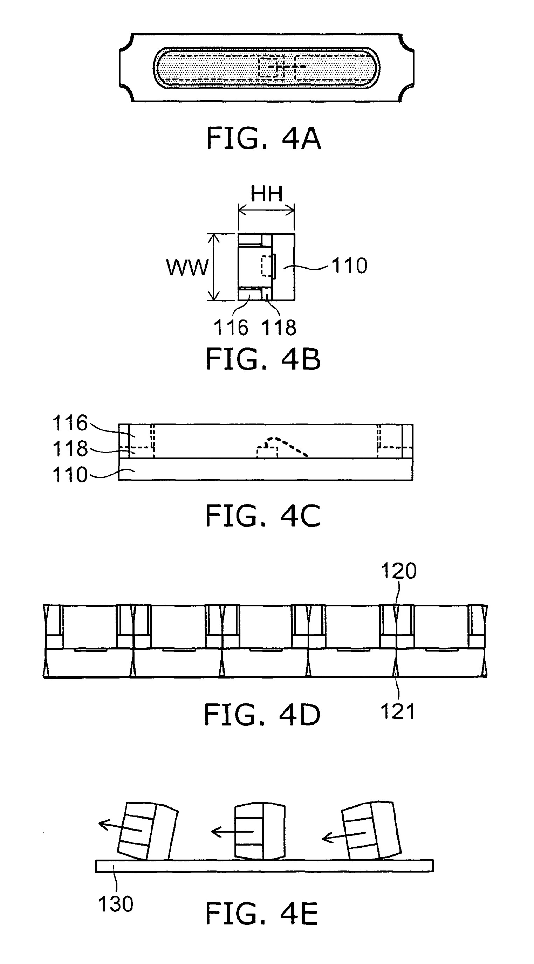

FIG. 4A is a schematic plan view of a light emitting device according to a comparative example, FIG. 4B is a schematic side view thereof, FIG. 4C is a schematic front view thereof, FIG. 4D is a schematic view illustrating a V-groove, and FIG. 4E is a schematic view showing the state of being attached to a mounting substrate.

On a first substrate 110, a second substrate 118 for isolation is laminated. A third substrate 116 is further laminated on the second substrate 118. For instance, a width WW of the laminated body can be 1 mm, and its height HH can be 0.8 mm. V-grooves 120, 121 are formed from the upper side and lower side of the laminated body to a depth of 1/2 to 1/3 of the height of the laminated body having a height of 0.8 mm, and the laminated body is separated using a roller or the like. Then, it is separated along the V-groove, but burrs, chips and the like are likely to occur. Hence, when the device is soldered to a mounting substrate, an optical axis of emitted light is likely to deviate from the horizontal axis as shown in FIG. 4E. Thus, if the device is used as a backlight source, the brightness of the screen may be nonuniform, which is undesirable for a side-view type device.

In contrast, in this embodiment, the outer edge 10m of the first substrate 10 and the outer edge 16m of the fourth substrate 16 are generally matched (their positions are generally aligned) with each other as viewed from above the mounting substrate. Hence, the optical axis is easily made generally parallel to the mounting substrate. Thus, when the device is used as a display backlight source, for instance, the brightness of the display screen can be easily made uniform.

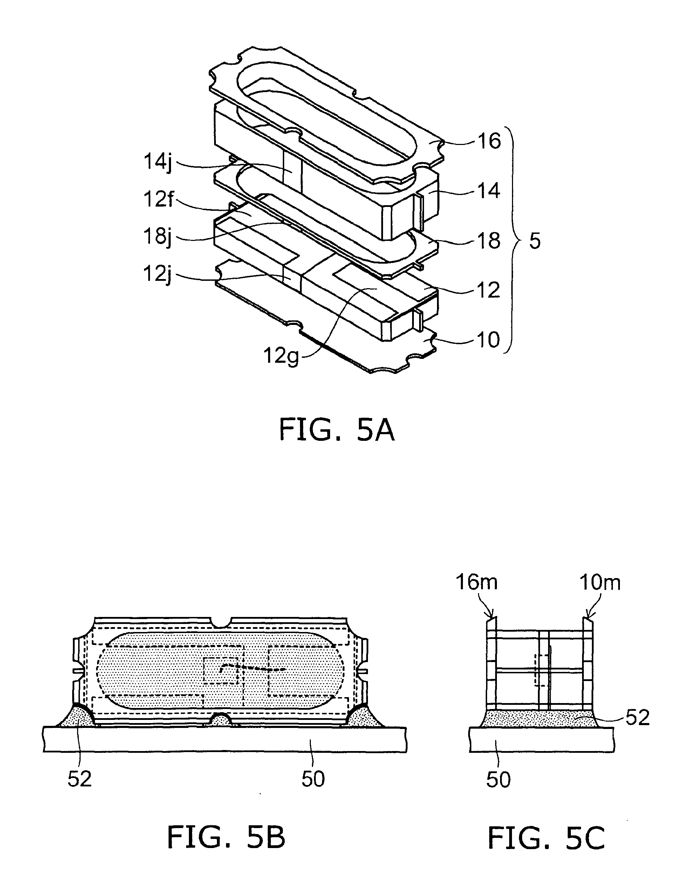

FIG. 5A is a schematic perspective view of substrates, before lamination, of a light emitting device according to a third embodiment, FIG. 5B is a schematic front view thereof, and FIG. 5C is a schematic side view thereof.

In this embodiment, the first electrode 12f can be extracted also from the lateral side of the laminated body 5. More specifically, a side electrode 12j connected to a bonding region of the first electrode 12f is provided on the side surface of the second substrate 12. This side electrode 12j can be connected by metallization to each of the side electrode 18j of the fifth substrate 18 for isolation, the side electrode 14j of the third substrate 14, and the side electrode 16j of the fourth substrate 16.

In the case where the substrates are made of Al₂O₃, because of its low thermal conductivity, heat generated in the light emitting element 40 is mostly dissipated through the first electrode 12f. The side electrode 12j allows heat dissipation through the side electrode 12j having a shorter path than heat dissipation through the first electrode 12f. More specifically, as shown in FIGS. 5B and 5C, there are three positions of soldering to the mounting substrate 50, allowing heat dissipation from the side electrode 12j to the mounting substrate 50 in a short distance. This can reduce the junction temperature of the light emitting element 40 during operation by generally 10°C.

Thus, at an operating current of 20 mA, an upper limit of atmosphere temperature can be increased from 85°C to 95°C. At an operating temperature of 60°C or less, an upper limit of operating current can be increased to generally 40 mA, which facilitates increasing brightness and improving reliability.

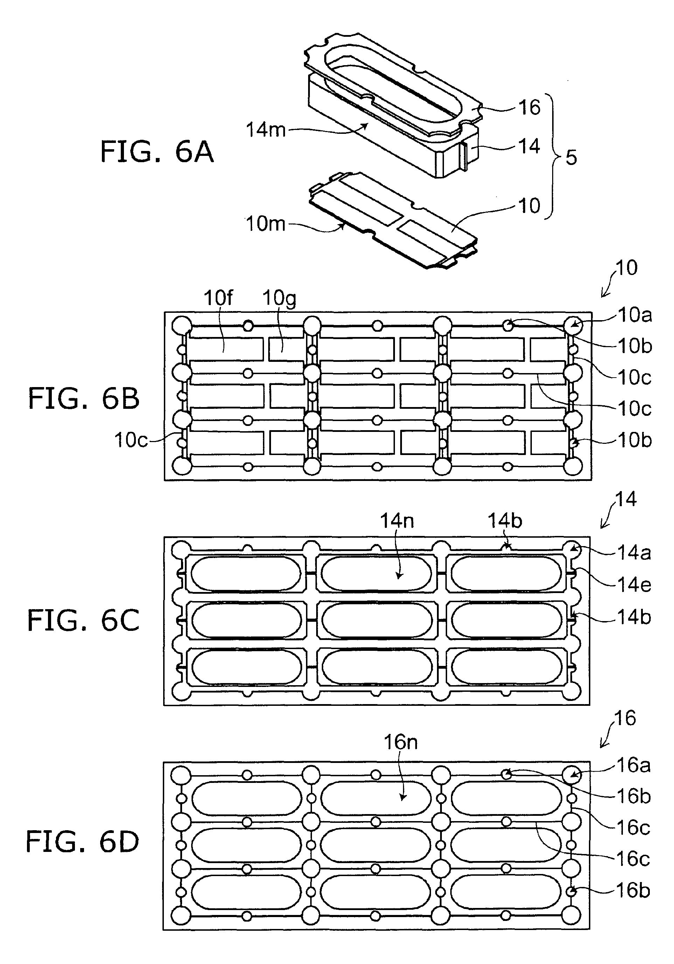

FIG. 6A is a schematic perspective view of the laminated body, before lamination, of a light emitting device according to a fourth embodiment, FIG. 6B is a schematic plan view of a first substrate, FIG. 6C is a schematic plan view of a third substrate, and FIG. 6D is a schematic plan view of a fourth substrate.

First electrodes 10f and second electrodes 10g are formed on a first substrate 10 having V-grooves 10c. A light emitting element 40 is to be bonded onto the first electrode 10f. Hence, preferably, the thickness of the first substrate 10 is e.g. 0.2 mm or more in view of bonding strength and stress reduction.

The third substrate 14 including through holes 14n is smaller in size than the first substrate 10 so that the outer edge 10m of the first substrate 10 is located outside the outer edge 14m of the third substrate. This allows a light emitting device of the top-view type to have a simpler structure than that of the first embodiment shown in FIG. 1.

A fourth substrate 16 is further provided. It has generally the same size as the first substrate 10, and is laminated so that the position of the V-groove 16c and the position of the V-groove 10c are generally matched (aligned) with each other. Then, the laminated body can be accurately separated by separation at the V-grooves 10c, 16c in the uppermost and lowermost substrate, allowing a light emitting device of the side-view type and top-view type to have a simpler structure than that of the second embodiment shown in FIG. 2.

The fourth embodiment can decrease the number of substrates and simplify the lamination process. Hence, the productivity of the package manufacturing process can be easily increased. This facilitates cost reduction. Furthermore, addition of a fifth substrate 18 for isolation facilitates providing a reflecting layer on the inner wall of the through hole 14n of the third substrate 14 to increase brightness.

The embodiments of the invention have been described with reference to the drawings. However, the invention is not limited to these embodiments. Those skilled in the art can variously modify the material, size, shape, layout and the like of the substrate, laminated body, electrode, light emitting element, V-groove, through hole, via hole, gas vent, phosphor particle, and sealing resin constituting the light emitting device, and such modifications are also encompassed within the scope of the invention unless they depart from the spirit of the invention.

## Claims

1. A light emitting device comprising:
a first substrate (10) with an end surface formed by separation on its outer edge;
a second substrate (12) including on its upper surface a first electrode and a second electrode, and at its side corner a first extraction electrode (22) connected to the first electrode and a second extraction electrode (20) connected to the second electrode, one end portion of the second electrode being opposed to one end portion of the first electrode, the second substrate (12) being laminated on the first substrate (10) so that an outer edge of the second substrate (12) is located inside the outer edge of the first substrate (10);
a light emitting element (40) bonded to the first electrode; and
a third substrate (14) including a first through hole which allows emission of emitted light from the light emitting element (40), the third substrate (14) being laminated on the second substrate (12) so that an outer edge of the third substrate (14) is located inside the outer edge of the first substrate (10).

2. A light emitting device comprising:
a light emitting element (40);
a first substrate (10) with an end surface formed by separation on its outer edge;
a second substrate (12) including on its upper surface a first electrode and a second electrode, at its side corner a first extraction electrode (22) connected to the first electrode and a second extraction electrode (20) connected to the second electrode, and on its side surface a side electrode connected to a bonding region of the first electrode on which the light emitting element (40) is bonded, one end portion of the second electrode being opposed to one end portion of the first electrode, the second substrate (12) being laminated on the first substrate (10) so that an outer edge of the second substrate (12) is located inside the outer edge of the first substrate (10);
a third substrate (14) including a first through hole which allows emission of emitted light from the light emitting element (40), the third substrate (14) being laminated on the second substrate (12) so that an outer edge of the third substrate (14) is located inside the outer edge of the first substrate (10); and
a fourth substrate (16) with an end surface formed by separation on its outer edge, the fourth substrate (16) including a second through hole having a size equal to or larger than the size of the first through hole, and the fourth substrate (16) being laminated on the third substrate (14) so that the outer edge of the fourth substrate (16) is generally matched with the outer edge of the first substrate (10).

3. The light emitting device according to claim 2, wherein an optical axis of the emitted light is generally parallel to a plane with which the outer edge of the first substrate (10) and the outer edge of the fourth substrate (16) are in contact.

4. The light emitting device according to claim 1 or 2, further comprising:
a fifth substrate (18) including a third through hole having a size generally equal to the size of the first through hole, the fifth substrate (18) being sandwiched between the second substrate (12) and the third substrate (14) and laminated so that an outer edge of the fifth substrate (18) is located inside the outer edge of the first substrate (10),
wherein a reflecting layer capable of reflecting part of the emitted light is formed on an inner wall of the first through hole.

5. The light emitting device according to claim 4, wherein the reflecting layer is made of a metal.

6. The light emitting device according to claim 4, wherein the inner wall of the first through hole has a bevel capable of reflecting part of the emitted light.

7. A light emitting device comprising:
a first substrate (10) with an end surface formed by separation on its outer edge, the first substrate (10) including on its upper surface a first electrode and a second electrode, and at its side corner a first extraction electrode (22) connected to the first electrode and a second extraction electrode (20) connected to the second electrode, one end portion of the second electrode being opposed to one end portion of the first electrode;
a light emitting element (40) bonded to the first electrode; and
a third substrate (14) including a first through hole which allows emission of emitted light from the light emitting element (40), the third substrate (14) being laminated above the first substrate (10) so that an outer edge of the third substrate (14) is located inside the outer edge of the first substrate (10).

8. The light emitting device according to claim 1 or 7, further comprising:
a fourth substrate (16) with an end surface formed by separation on its outer edge, the fourth substrate (16) including a second through hole having a size equal to or larger than the size of the first through hole, and the fourth substrate (16) being laminated on the third substrate (14) so that the outer edge of the fourth substrate (16) is generally matched with the outer edge of the first substrate (10).

9. The light emitting device according to claim 7, further comprising:
a fifth substrate (18) including a third through hole having a size generally equal to the size of the first through hole, the fifth substrate (18) being sandwiched between the first substrate (10) and the third substrate (14) and laminated so that an outer edge of the fifth substrate (18) is located inside the outer edge of the first substrate (10),
wherein a reflecting layer capable of reflecting part of the emitted light is formed on an inner wall of the first through hole.

10. The light emitting device according to claim 9, wherein the reflecting layer is made of a metal.

11. The light emitting device according to claim 9, wherein the inner wall of the first through hole has a bevel capable of reflecting part of the emitted light.

12. The light emitting device according to claim 1 or 2, wherein the first, second, and third substrates (10,12,14) are all made of a ceramic, or all made of a glass epoxy.

13. The light emitting device according to claim 7, wherein the first and third substrates (10,14) are all made of a ceramic, or all made of a glass epoxy.

14. The light emitting device according to one of claims 1, 2, and 7, further comprising:
a sealing resin (29) filled in the first through hole.

15. The light emitting device according to claim 14, further comprising:
phosphor particles dispersed in the sealing resin (29) and being capable of absorbing the emitted light and emitting wavelength-converted light.
